# EUROPEAN PATENT APPLICATION

(11) **EP 2 665 189 A1**
(43) Date of publication of application: **20.11.2013**
(21) Application number: 13167731.2
(22) Date of filing: 14.05.2013
(51) Int. Cl.: H03K 17/96

(54) **Capacitive control push-button panel for residential electrical series**

(30) Priority: 16.05.2012 IT MI20120850
(71) Applicant: Comelit Group S.p.a., 24020 Rovetta San Lorenzo (BG) (IT)
(72) Inventor: Rifino, Innocenzo, 20129 Milano (IT); Rossi, Diego, 29121 Piacenza (IT)
(74) Representative: Petruzziello, Aldo

(57) **Abstract**

A description is given of a capacitive control push-button panel for residential electrical series, comprising: a front panel (40) with screen-printed on the rear a plurality of icons (42) arranged so as to cover all possible control configurations; a rear CapSense printed circuit board with a plurality of sensitive areas (31), each one of which can be associated to a required command, and a plurality of back-lighting LEDs (32) arranged in perfect alignment with said plurality of icons (42) provided on the back of the front panel (40); said sensitive areas (31) can be selectively activated by software, so as to determine particular configurations of the push-button panel, with lighting of corresponding icons (42) on the front panel (40), touching or skimming which a relative load is controlled.

## Description

The object of the present invention is a capacitive control push-button panel for residential electrical series, which can be configured according to the electrical loads which are to be controlled.

The residential electrical series currently existing on the market provide, in almost all cases, electromechanical controls for actuating electrical devices (wallplates) such as switches, change-over switches, diverters, dimmers, etc.

The wallplates are housed in a flush-mount box, mounted on a special support frame, with the control members projecting frontally enclosed in an external cover plate with mainly aesthetic function.

It is clear that according to the various electrical requirements different wallplates are necessary with relative control members, so that the specific need of the different rooms is fulfilled. For example, if it is necessary to control three lights, the plate has to be set up with three generic push-buttons. If however in the same room, in addition to the three lights, three shutters also have to be controlled, a larger flush-mount box would have to be used, with relative different cover plate, and different push-buttons placed alongside the light actuation push-buttons with suitable screen-printing for controlling the motors of the three shutters. Alternatively two boxes and corresponding plates for three modules rather than one for six would have to be used.

In practice the technology with electromechanical controls responds to different needs by modifying, removing or adding elements on the basis of the loads to be controlled.

The disadvantages of such a technology are evident, which technology requires a large variety of components in order to fulfil the many electrical requirements.

There are also, to a lesser extent, controls of the capacitive type which provide an external covering, normally in glass, below which a printed circuit is placed with conductive copper areas and sensors, in such a way that by touching with a finger the glass covering in certain zones appropriately screen-printed externally a variation in capacity is produced with which the associated load is controlled.

US5239152 describes a panel with capacitive tactile sensor provided with graphic symbols/alphanumerical characters and defined by a dielectric flat substrate comprising a plurality of layers, an optical filter, a light source for the lighting of the graphic symbols, and means of capacitive sensorisation juxtaposed on said graphic symbols for the detection of the touch/pressure exerted by the user on the panel and the transmission of the relative signal to switches for enabling specific controls/functions.

US2005/0134485 describes a tactile panel used on a motor vehicle comprising at least one area associated to said panel and at least one non-mechanical switch of the resistive, inductive, capacitive or piezoelectric type placed to the rear of this area and suitable for enabling/disabling electrically a specific device of the vehicle, with said area associated to a sensitive region of the switch, the panel provided with sources of LED lighting associated to the indicators of the switches.

These controls of the capacitive type also have the disadvantage of having to be configured mainly as a function of the electrical load to be controlled, not being able to be modified subsequently, unless by replacing the components thereof, for example the covering in glass with a different screen-printing and the same underlying printed circuit.

In practice, therefore, the capacitive controls currently in existence also have the same disadvantages of the electromechanical controls, due to the plurality of dedicated setups for which they are intended.

The object of the invention is that of eliminating the disadvantages of the control systems for residential series, both electromechanical and capacitive, providing a push-button panel which is able to modify easily its interface and have on each occasion a different function.

Another object of the invention is that of providing such a push-button panel which can be configured as a function of the different electrical needs, without having to modify, add, replace components.

Yet another object of the invention is that of providing such a push-button panel which can be preset with different configurations which can be activated selectively for the control of different loads.

These and other objects of the invention are achieved with the features disclosed in the annexed independent claim 1.

Advantageous embodiments of the invention are disclosed by the dependent claims.

Substantially, the capacitive control push-button panel for residential electrical series according to the invention comprises a front panel, preferably in opaque glass, with screen-printed on the rear a plurality of icons arranged so as to cover all possible control configurations; a rear CapSense printed circuit board with a plurality of sensitive areas, each of which can be associated to a desired command, and a plurality of back-lit balls arranged in perfect alignment with said plurality of icons provided on the rear of the front panel; said sensitive areas can be selectively activated by software, so as to determine a particular push-button panel configuration, with lighting of corresponding icons on the front panel, touching or skimming which a relative load is controlled.

The push-button panel according to the invention also comprises a board of interface to a home automation bus, such as SimpleHome, Technobus, Eyelink protocol bus.

The capacitive electronics of the push-button panel is able to recognise some gestures, in particular the gesture of passing the hand over the front panel allows a "page change" and therefore a different configuration of the controls of the push-button panel to be activated.

During the phase of set-up of the system it will be possible to define which configuration(s) to be used during the functioning phase, configuration which is displayed by lighting the icons on the front panel reproducing the relative push-buttons.

Further features of the invention will be made clearer by the following detailed description, referred to one of its embodiments purely by way of a non-limiting example illustrated in the accompanying drawings, in which:
Fig. 1 is an exploded schematic view illustrating the push-button panel according to the invention and the means which allow a wall installation thereof, in particular in a rectangular flush-mount box;
Figure 1a is a view similar to Fig. 1, illustrating the assembly of the push-button panel in a round flush-mount box;
Fig. 2 is a schematic plan view of the CapSense control board, shown with a configuration slightly different from that of Figures 1 and 1a;
Fig. 3 is a schematic plan view of the front panel, corresponding to the board of Fig. 2 where the various icons are to be understood as screen-printed on the rear of the panel;
Figs. 4 to 8a), b), c) illustrate some of the possible configurations of controls which can be obtained with the push-button panel according to the invention, where a) are views of the CapSense board like Fig. 2 with highlighting of the sensitive areas activated according to the controls to be given; b) are views of the front panel like that of Fig. 3 with highlighting of the icons corresponding to the control configurations of views a); c) are photographic views of the push-button panel in the configurations corresponding to the respective views a), b);
Fig. 9 is a photographic view schematising the gesture recognition of the page change of the push-button panel.

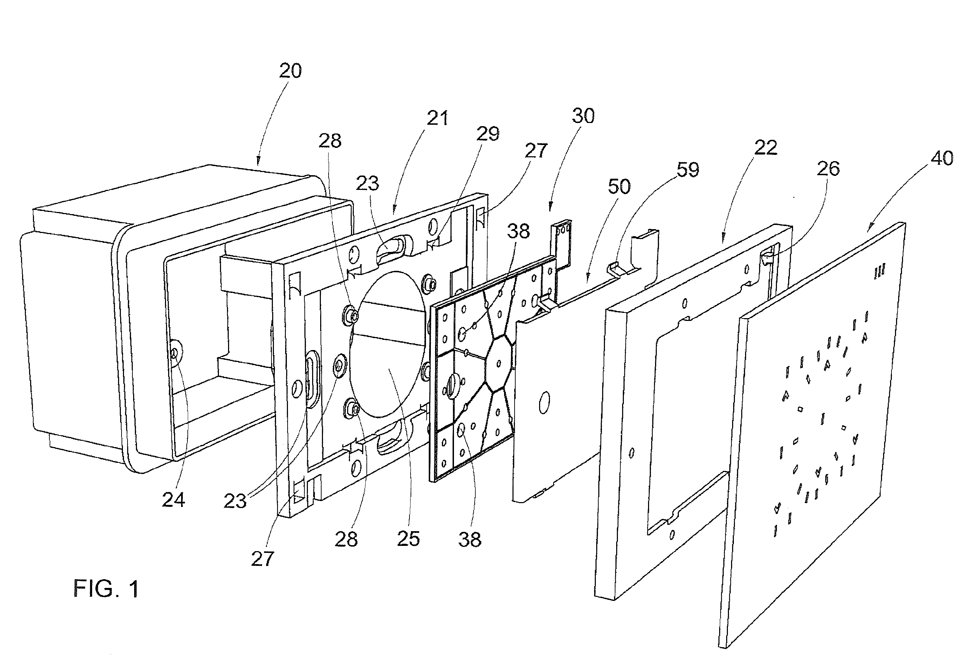

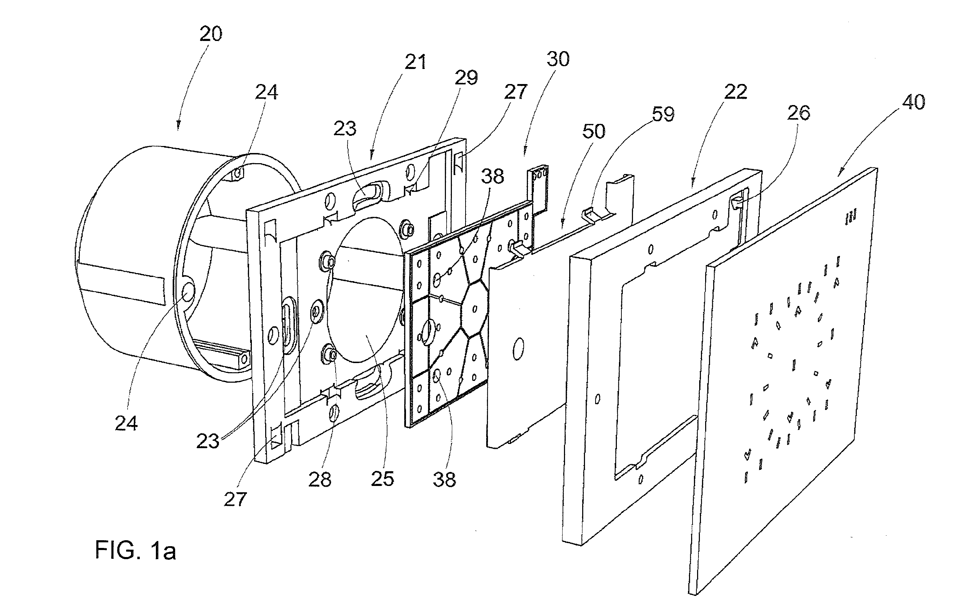

Referring initially to Fig. 1, reference numeral 10 denotes the capacitive control push-button panel for residential electrical series according to the invention, which in this case is schematically illustrated exploded for the assembly in a usual flush-mount wall box 20, by means of a support frame 21, which has the shape of a square or rectangular frame, which in a manner in itself known is attached to the box 1 for example by means of screws, not shown, inserted in slots or holes 23 provided in the frame 21 and screwing in seats 24 provided in the box 20.

In the embodiment illustrated the support frame 21 has a circular central opening 25, so as to be able to adapt both to a rectangular box (Fig. 1) and a round box (Fig. 1a). The push-button panel in itself comprises substantially a printed circuit board 30 and a front panel 40, which in the preferred embodiment is in opaque glass, but which obviously could be in any other suitable material such as Plexiglas and the like.

In Fig. 1 and 1a a mask 22 can also be seen in the form of a rectangular frame which is attached for example by gluing on the back of the front panel 40 and/or carries means for the attachment for example by slotting to the support frame 21. In the embodiment illustrated these means are made up of teeth 26 which engage in corresponding holes 27 provided in the support frame 21.

In the embodiment shown in Figs. 1 and 1a, the printed circuit board 30 also carries means of hooking to the support frame 21, made up in this case by holes 38 engaging with pins 28 projecting frontally from the support frame 21.

Figures 1 and 1a also show a diffusing screen 50 placed frontally to the board 30, suitable for improving and making more uniform the emission of the LEDs provided on the back of the board 30, as will be stated herein below. The screen 50 covers the printed circuit board 30 and is attached to the support frame 21 by means of teeth 59 which engage in corresponding seats 29 of the frame 21.

After assembly everything remains recessed in the wall, with the exception of the front panel 40 which remains in sight, preferably flush with the wall, optionally enclosed in an external perimeter frame with purely aesthetic function.

Naturally what is illustrated in Figs. 1 and 1a is purely indicative, and the push-button panel 10 according to the invention, constituted substantially by the printed circuit board 30 and by the front panel 40, can be mounted in any other way, making the necessary electrical connections not shown in the drawings.

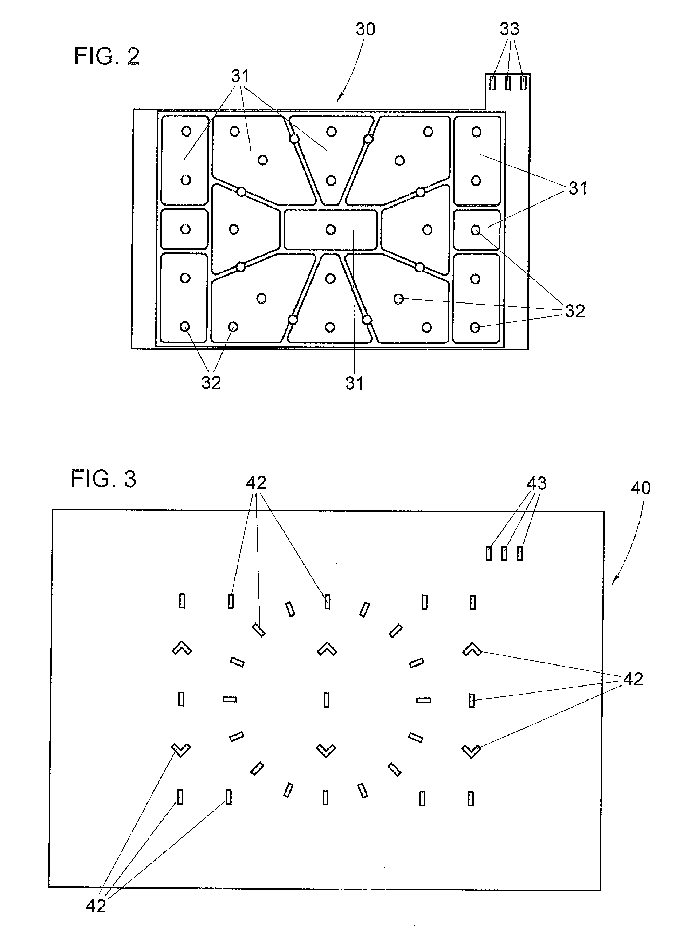

Fig. 2 is a plan view of the printed circuit board 30, shown in a configuration slightly different from that of Figures 1 and 1a. In fact the particular configuration of the board 30 is not essential for the purpose of the present invention. It has a plurality of sensitive areas, denoted generically by reference numeral 31, distributed practically over the entire surface of the board.

In the embodiment illustrated, which is the one considered more convenient for the various controls which can be given, three rectangular areas of suitable dimensions are provided on each of the two vertical sides of the board, and a further rectangular area is provided centrally to the same. Around the central rectangular area eight polygonal areas then develop, in particular triangular or trapezoidal.

The distribution of the sensitive areas in the board 30 shown in Figures 1 and 1a is practically the same, their configuration only changes slightly and starts for example from a central octagonal area.

In each of said sensitive areas 31 at least one back-lit, in particular by means of an RGB LED, ball 32 is provided. A back-lit ball 32 is provided also between pairs of adjacent polygonal areas, so as to form, together with other balls provided in these areas, a circumferential contour.

The back-lighting RGB LEDs 32, when lit, highlight the corresponding areas or active keys. At the top right of the board 30, outside of the profile which encloses the sensitive areas 31, three small rectangles 33 are provided which represent the same number of back-lighting RGB LEDs which in the case in question identify the page in use with respect to three available.

Fig. 3 is a plan view of the front opaque glass panel 40 with all the icons shown, denoted by reference numeral 42, screen-printed on the back of the same, which are arranged in perfect alignment with the underlying back-lighting RGB LEDs 32, in such a way that, on the basis of the chosen configuration, the icons corresponding to the control keys activated are highlighted, as will be described briefly herein below.

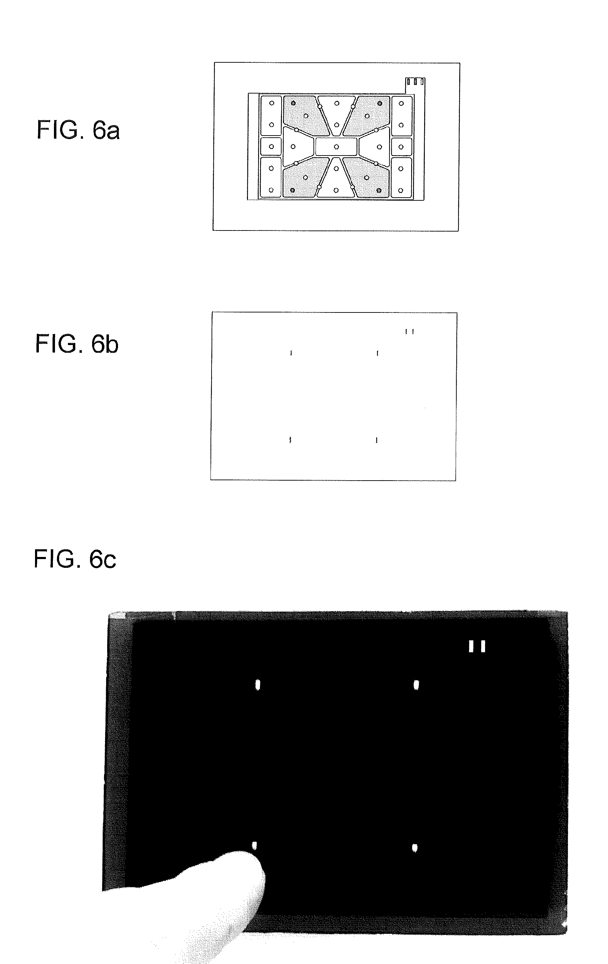

On the back of the glass panel 40 three small rectangles 43 are also screen-printed top right which are arranged in alignment with the underlying RGB LEDs 33, which light up in sequence, as a function of the page in use.

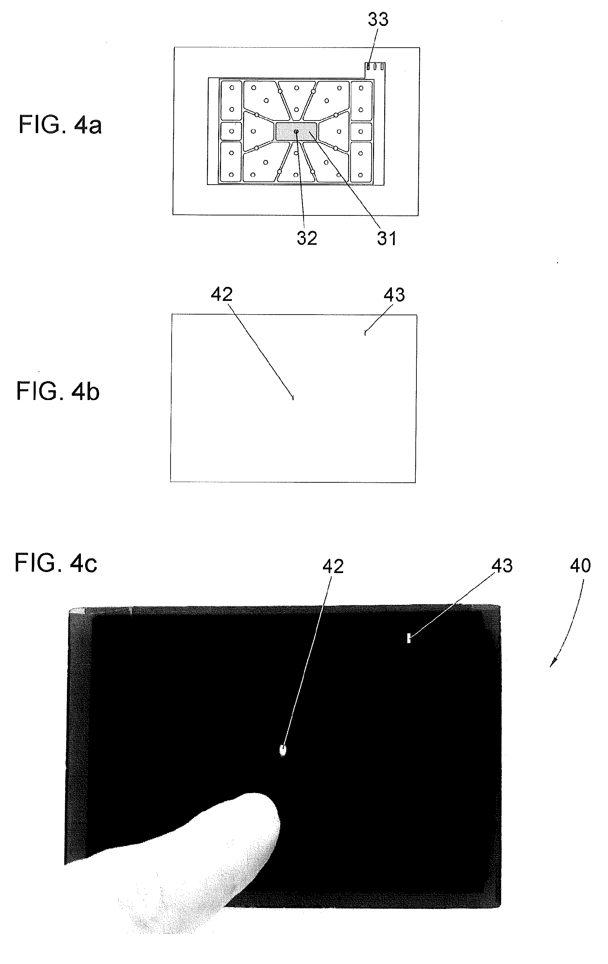

Figs. 4 a), b), c) illustrate the push-button panel according to the invention in 1 switch configuration. In particular Fig. 4 a) highlights the sensitive area 31 of the central rectangle acting as key of the switch, and the corresponding back-lighting LEDs 32, as well as the first small rectangle 33 indicating the page in use.
Fig. 4 b) illustrates schematically the icons 42, 43 which appear on the rear front panel 40 in the configuration with one switch.
Fig. 4 c) is instead a photographic representation of the push-button panel showing the lit icons 42, 43 shown in Fig. 4b

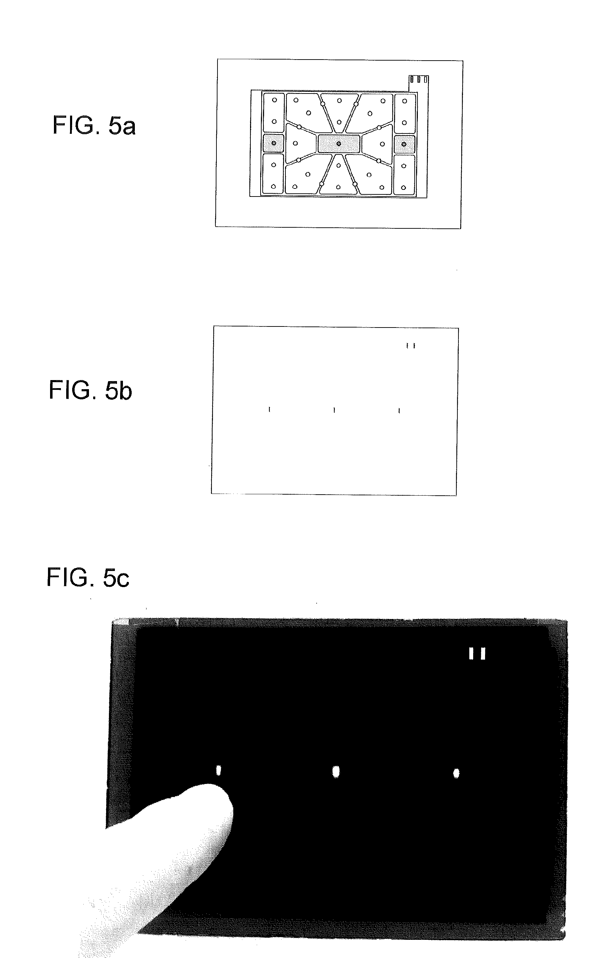

Figs. 5 to 8 illustrate other possible configurations of the push-button panel, in views similar respectively to those of Figs. 4 a), b), c).
In particular Fig. 5 illustrates a configuration with three switches, one central and two lateral; Fig. 6 a configuration with four switches situated at the four angular polygonal areas which surround the central area;

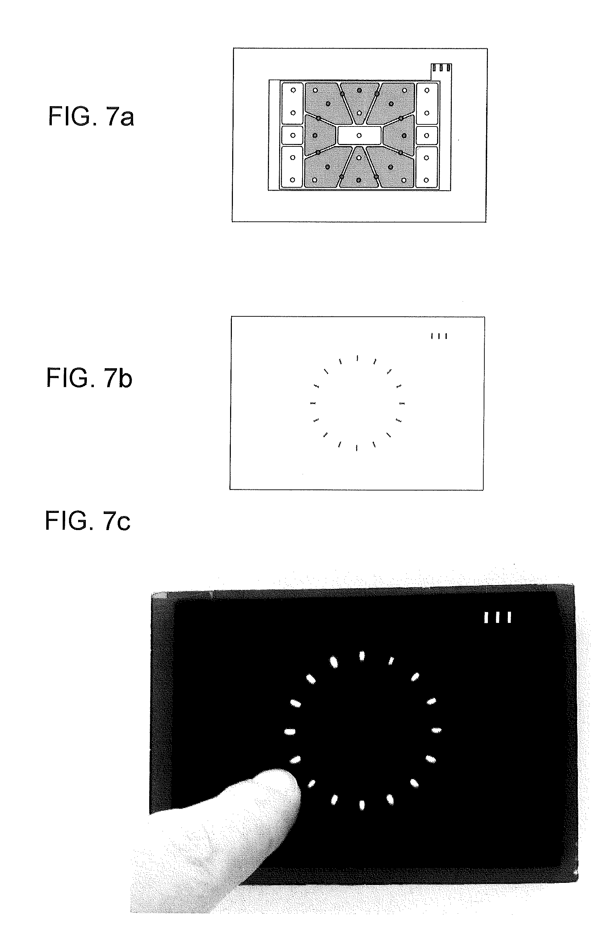

Fig. 7 illustrates a dimmer configuration, wherein all the polygonal sensitive areas which surround the central area are activated, such that the corresponding icons on the front glass panel 40 form a circle; or wheel;

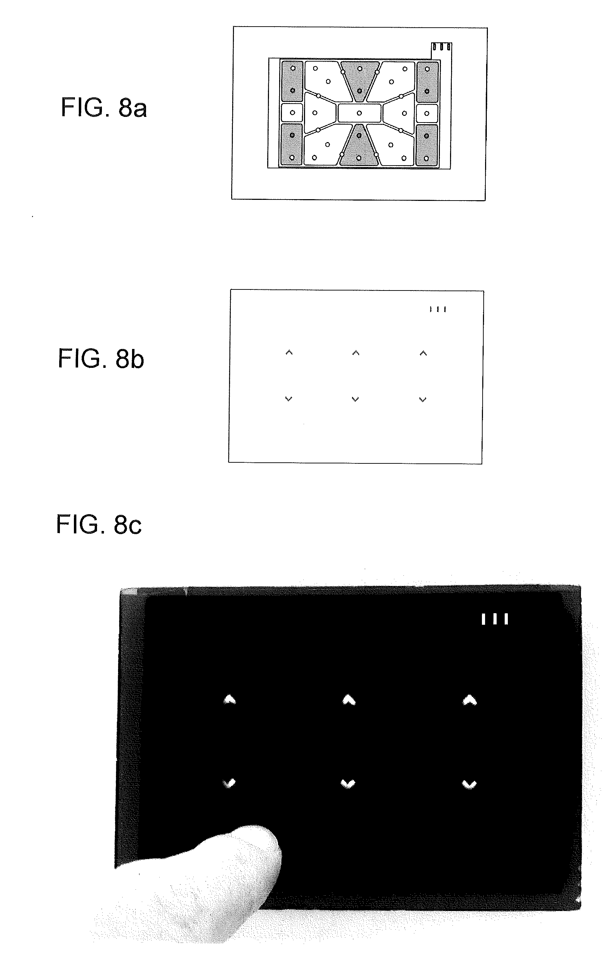

Fig. 8 relates to a configuration with three up-down push-buttons for a total of six sensitive areas, arranged centrally and at the two sides of the push-button panel, respectively in the upper part and in the lower part.

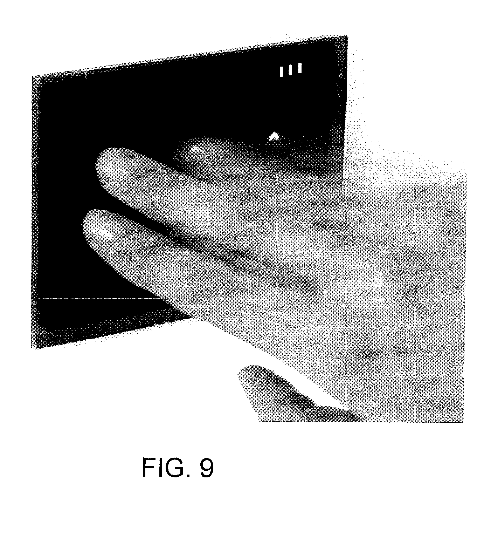

Fig. 9 shows schematically the function of gesture recognition of the push-button panel according to the invention, with which by sliding the fingers in one direction or in the other on the front glass panel 40 a page change is brought about passing from one control configuration set to another.

The printed circuit board 30 generically indicated in the drawings is in practice made up of two or three boards: one front base board which performs the functions of management of the capacitive part for the definition of the sensitive areas 31 and for the management of the RGB LEDs 32, and a rear plug-in board of interface towards a home automation bus with communications in Technobus, SimpleHome, Eyelink protocol and the like. Optionally the board of capacitive management of the sensitive areas can be separated from that of the LEDs, thus bringing to three the number of the sandwich boards.

The configurations used in the phase of functioning are defined during the phase of set-up of the system, selecting them from software. The back-lighting LEDs 32 are of the RGB type, so as to be able to light with a different colour the icons corresponding to the active keys, as a function of the status of the same, for example blue for the off status and red for the on status.

A feedback may be provided at the time of pressing or skimming of an active key, for example a micro-vibration of the push-button panel and/or a sound.

A luminosity sensor may also be provided which provides for regulating, if enabled, the intensity of the LEDs of identification of the various push-buttons. The front panel 40 can be provided normally with the back-light illumination switched off and the push-buttons positioning LEDs switched off. In this case both the back-light and the push-buttons light up to represent the possible state of the load, by bringing a hand close, and switch off again after a timeout time which can be set from software.

From what has been disclosed the advantages of the capacitive control push-button panel according to the invention appear clear and which, unlike the systems currently existing on the market, allows a single control member to be provided which can be configured as a function of the various electrical requirements.

Naturally the invention is not limited to the particular embodiment previously described and illustrated in the accompanying drawings, but instead numerous detail changes can be made thereto, within reach of the person skilled in the art, without thereby departing from the scope of the same invention as defined in the annexed claims.

## Claims

1. Capacitive control push-button panel for residential electrical series, comprising:
- a front panel (40) with screen-printed on the back a plurality of icons (42) arranged so as to cover all possible control configurations;
- a rear CapSense printed circuit board with a plurality of sensitive areas (31), each one of which can be associated to a desired command, and a plurality of back-lighting LEDs (32) provided in each of said sensitive areas and between pairs of adjacent areas and arranged in a perfect alignment with said plurality of icons (42) provided on the rear of the front panel (40), said sensitive areas (31) can be selectively activated by software, so as to determine particular configurations of the push-button panel, with lighting of corresponding icons (42) on the front panel (40), touching or skimming which a relative load is controlled,
- capacitive electronics capable of recognising gestures, the gesture of passing the hand over said front panel (40) allowing switching from one control configuration to another by means of "page change".

2. Push-button panel according to claim 1, **characterised in that** said front panel (40) is in opaque glass, Plexiglas or the like.

3. Push-button panel according to claim 1 or 2, wherein said back-lighting LEDs 32 are RGB LEDs and light the relative icons 42 with a different colour depending on the status of the underlying sensitive area (31).

4. Push-button panel according to any one of the preceding claims, **characterised in that** said printed circuit board (30) also comprises further back-lighting RGB LEDs (33) in alignment with corresponding icons (43) screen-printed on the back of said front panel (40), suitable for indicating the same number of preset control configurations.

5. Push-button panel according to any one of the preceding claims, wherein said printed circuit board (30) comprises at least one board for the capacitive management for the definition of said sensitive areas (31) and the management of said back-lighting LEDs (32), and a board of interface towards a home automation bus.

6. Push-button panel according to any one of the preceding claims, **characterised in that** it also provides a diffusing screen (50) placed frontally to the printed circuit board (30), suitable for improving and making the emission of said LEDs more uniform.

7. Push-button panel according to any one of the preceding claims, **characterised in that** it provides a feedback at the time of pressing or skimming said front panel (40), at the active sensitive areas (31), in the form of micro-vibration and/or sound.

8. Push-button panel according to any one of the preceding claims, wherein said sensitive areas (31) of the printed circuit board (30) comprise three polygonal areas of different dimensions arranged at each of the two sides of the board, a central polygonal area and a plurality of polygonal areas surrounding said central area, in each of said areas (31) being provided at least one back-lighting LED (32) and a further LED (32) is arranged between each of said polygonal areas, so as to form a circle.

9. Push-button panel according to any one of the preceding claims, which can be installed in a flush-mount wall box (20) by means of a support frame (21).

10. Push-button panel according to claim 9, wherein a mask (22) is provided which can be attached on the rear of said front panel (40) and provided with means of attachment to said support frame (21).
